(19) **Europäisches Patentamt**

**European Patent Office**

**Office européen des brevets**

(11) **EP 0 821 477 B1**

(12) **EUROPÄISCHE PATENTSCHRIFT**

(45) Veröffentlichungstag und Bekanntmachung des Hinweises auf die Patenterteilung:
**02.04.2003 Patentblatt 2003/14**

(51) Int Cl.⁷: **H03G 1/00**, H03G 3/00, H03H 11/24

(21) Anmeldenummer: **97112855.8**

(22) Anmeldetag: **25.07.1997**

(54) **Digital steuerbare Dämpfungsschaltung für Audiosteller**

Digitally controllable attenuator circuit for audio

Circuit atténuateur à commande numérique audio

(84) Benannte Vertragsstaaten:
**FR GB IT**

(30) Priorität: **26.07.1996 DE 19630331**

(43) Veröffentlichungstag der Anmeldung:
**28.01.1998 Patentblatt 1998/05**

(73) Patentinhaber: **SGS-THOMSON MICROELECTRONICS GMBH**
**85630 Grasbrunn (DE)**

(72) Erfinder: **Viebach, Michael**
**83059 Kolbermoor (DE)**

(74) Vertreter: **Hirsch, Peter, Dipl.-Ing.**
**Klunker Schmitt-Nilson Hirsch**
**Winzererstrasse 106**
**80797 München (DE)**

(56) Entgegenhaltungen:
US-A- 5 091 728          US-A- 5 231 360
US-A- 5 523 712

• HYNES ET AL: "A CMOS digitally Controlled Audio Attenuator for Hi-Fi Systems" IEEE JOURNAL OF SOLID-STATE CIRCUITS., Bd. sc, Nr. 16, Februar 1981, Seiten 15-20, XP002107893 NEW YORK US
• PATENT ABSTRACTS OF JAPAN vol. 005, no. 099 (E-063), 26. Juni 1981 & JP 56 043822 A (MATSUSHITA ELECTRIC IND CO LTD), 22. April 1981

**Beschreibung**

Die Erfindung betrifft eine digital steuerbare elektrische Dämpfungsschaltung zum steuerbaren Dämpfen eines Audiosignals.

Bei heutigen Audiogeräten, die monolithisch integrierte Audiosignalprozessoren aufweisen, werden Signaldämpfungsvorgänge, z.B. im Zusammenhang mit Lautstärkestellern, Höhenstellern und Tiefenstellern, häufig mittels digital steuerbarer Dämpfungsschaltungen durchgeführt.

Herkömmliche digital steuerbare Dämpfungsschaltungen weisen üblicherweise aus Widerstandsketten aufgebaute Spannungsteiler auf, die eine Anzahl Teilspannungsabgriffe besitzen, die je mit einem steuerbaren elektronischen Schalter verbunden sind, wobei die einzelnen Schalter mittels digitaler Steuersignale derart steuerbar sind, daß immer einer der Schalter leitend und die jeweils anderen Schalter nichtleitend gesteuert sind.

Nachteilig ist dabei, daß über eine derartige Widerstandskette stets Querströme fließen, was zu entsprechenden Verlustleistungen führt.

Gleiches gilt für eine digital steuerbare Dämpfungsschaltung, wie sie bekannt ist aus Patent Abstracts of Japan, E-63 June 26, 1981 Vol. 5 No. 99, 56-43822 (A). Diese Dämpfungsschaltung umfaßt zwischen einem Signaleingang und einem Signalausgang vier in Reihe geschaltete Dämpfungsstufen, die je einen Längszweig aus einer Parallelschaltung aus einem Längswiderstand und einem steuerbaren Längsschalter und am signalausgangsseitigen Ende des je zugehörigen Längswiderstandes je einen Querzweig aus einem Querwiderstand und einem dazu in Reihe geschalteten steuerbaren Querschalter aufweisen. Dem Querzweig der signalausgangsseitigen Dämpfungsstufe ist ein nicht schaltbarer Widerstand parallel geschaltet. Die beiden Schalter einer jeden Dämpfungsstufe stehen unter der Steuerung einer je zugehörigen Steuerstufe einer digitalen Ansteuerschaltung. Nach den in der Figur dieser Druckschrift dargestellten Schaltstellungen der Schalter besteht die Möglichkeit, daß die beiden Schalter einer jeden Dämpfungsstufe in je gegenläufige Schaltzustände gesteuert werden. Unabhängig davon, welches Schaltstellungsmuster die Schalter dieser Dämpfungsschaltung jeweils haben, fließt immer ein Querstrom.

Aus HYNES ET AL: 'A CMOS digitally Controlled Audio Attenuator for Hi-Fi Systems' IEEE JOURNAL OF SOLID-STATE CIRCUITS., Bd. sc, Nr. 16, Februar 1981, Seiten 15-20, NEW YORK, US ist eine weitere digital gesteuerte Dämpfungsschaltung zum Dämpfen eines Audiosignals bekannt, wobei die Dämpfungsschaltung einen D/A-Wandler enthält. Aus US-A-5 091 728 ist ein D/A-Wandler bekannt, der als digital steuerbare Dämpfungsschaltung zum steuerbaren Dämpfen eines Audiosignals geeignet ist.

Mit digital gesteuerten Dämpfungsschaltungen lassen sich Dämpfungsänderungen nicht kontinuierlich steuern sondern nur in Quantensprüngen. Für eine feine Abstufung der Dämpfungsänderungen benötigt man Widerstandsketten mit einer entsprechend großen Anzahl von Teilwiderständen und Teilspannungsabgriffen verbundene elektronische Schalter. Oder man verwendet eine grobteilende Widerstandskette und eine feinteilende Widerstandskette in Kaskadenschaltung.

Mit der vorliegenden Erfindung wird eine Dämpfungsschaltung verfügbar gemacht, welche einerseits keine Querstromverluste bei minimaler und bei maximaler Dämpfung aufweist und andererseits eine Feinabstufung der Einstellbarkeit der Dämpfung mit vergleichsweise wenigen Bauelementen ermöglicht.

Die Erfindung, die in Anspruch 1 definiert ist, schafft eine digital steuerbare elektrische Dämpfungsschaltung für Audiosteller, die einen

Audiosignaleingang aufweist, einen Audiosignalausgang und einen Steuersignaleingang für den Empfang eines n-stelligen Datenwortes von einer digitalen Ansteuerschaltung, wobei n eine vorbestimmte ganze Zahl ist und wobei die Dämpfungsschaltung eine zwischen den Audiosignaleingang und einen Signalmasseanschluß geschaltete Parallelschaltung mit n Dämpfungsgliedern enthält, die je aufweisen: einen mit dem Audiosignalausgang verbundenen Teilspannungsabgriff, eine zwischen den Audiosignaleingang und den Teilspannungsabgriff geschaltete erste Reihenschaltung mit einem ersten Widerstand und einem ersten steuerbaren Schalter, eine zwischen den Teilspannungsabgriff und den Signalmasseanschluß geschaltete zweite Reihenschaltung mit einem zweiten Widerstand und einem zweiten gesteuerten Schalter und eine Schaltersteuereinrichtung, über welche die beiden Schalter eines jeden Dämpfungsgliedes gegenläufig steuerbar sind, derart, daß jeweils einer der beiden Schalter leitend und der jeweils andere Schalter nichtleitend geschaltet ist, und wobei den Schaltersteuereinrichtungen der Dämpfungsglieder je eine andere der n Stellen des Datenwortes als Schaltsteuersignal zuführbar ist.

Daß bei der erfindungsgemäßen Dämpfungsschaltung die Dämpfungsglieder je zwei in einer Reihenschaltung befindliche Schalter aufweisen, von denen immer einer nichtleitend geschaltet ist, führt dazu, daß bei minimaler und bei maximaler Dämpfung keine Querströme durch die Dämpfungsglieder fließen und somit keine Querstromverlustleistungen auftreten. Und da für die Einstellung eines bestimmten Dämpfungswertes nicht eine Vielzahl von Teilwiderständen, die alle in Reihe geschaltet sind, verwendet wird sondern eine Anzahl von parallel geschalteten Dämpfungsgliedern mit je nur zwei in Reihe geschalteten Widerständen, wobei digital steuerbar ist, welche der zwischen Audiosignaleingang und Teilspannungsabgriff sowie zwischen Teilspannungsabgriff und Signalmasse jeweils parallel geschaltet werden, kommt man schon bei Verwendung einer relativ kleinen Anzahl solcher parallel geschalteter Dämpfungsglieder zu einer großen Anzahl zueinander relativ fein abgestufter Dämpfungswerte.

Die erfindungsgemäße Dämpfungsschaltung ist gänzlich mit Schaltungskomponenten realisierbar, die sich problemlos schon mit einfachen CMOS-Prozessen monolithisch integrieren lassen.

Vorzugsweise sind die Widerstandswerte der Widerstände der einzelnen Dämpfungsglieder verschieden, und zwar in Abhängigkeit von den Wertigkeiten der den einzelnen Dämpfungsgliedern zugeordneten Stellen des Datenwortes.

Besonders bevorzugt wird eine Dämpfungsschaltung, bei welcher die Schalter der Dämpfungsglieder je mit einem MOS-Schalter aufgebaut sind, der die Doppelfunktion sowohl des Schalters als auch des zugehörigen Widerstandes hat, wobei dessen Einschaltwiderstand den je zugehörigen Widerstand des Dämpfungsgliedes bildet.

Jeder der MOS-Schalter kann durch einen einzigen MOS-Transistor realisiert werden. Bevorzugtermaßen wird jedoch jeder der MOS-Schalter mit einer Parallelschaltung aufgebaut, die einen einen N-Kanal aufweisenden NMOS-Transistor und einen einen P-Kanal aufweisenden PMOS-Transistor aufweist, die immer gleichzeitig leitend oder nichtleitend schaltbar sind, wobei im Einschaltzustand deren parallel zueinanderliegende Einschaltwiderstände den je zugehörigen Widerstand des Dämpfungsgliedes bilden. Mit dieser Ausführungsform läßt sich eine weiter reichende Linearität für den resultierenden Einschaltwiderstand erreichen als bei der Verwendung nur eines einzigen MOS-Transistors pro Schalter, und damit lassen sich Verzerrungen des Audiosignals noch kleiner halten.

Eine erfindungsgemäße Dämpfungsschaltung läßt sich z.B. auch vorteilhaft für digital gesteuertes weiches Muting oder Stummschalten verwenden. Anhand dieses Beispiels soll nachfolgend auch die Funktion einer Ausführungsform einer erfindungsgemäßen Dämpfungsschaltung erklärt werden. In diesem Fall verwendet man zur digitalen Ansteuerung vorzugsweise einen Aufwärts/Abwärtszähler. Läßt man den Zähler während eines Mutingvorgangs seinen Zählwert verändern, indem man ihn während dieses Vorgangs Taktimpulse zählen läßt, ändert sich laufend der von der Dämpfungsschaltung erzeugte Dämpfungsfaktor. Bei ausreichend großem Zählwertbereich und entsprechender Bemessung der digital steuerbaren Dämpfungsschaltung kann man dann einen weichen Mutingvorgang ablaufen lassen, während welchem das stumm zu steuernde oder aus dem Stummzustand herauszuführende Audiosignal bis auf die Signalamplitude null herabgedämpft bzw. die Dämpfung von der Signalamplitude null aus wieder zunehmend verringert wird.

Der Einfachheit halber soll nachfolgend der Begriff Stummschalten nicht nur den Vorgang des Dämpfens des Audiosignals in den Stummzustand sondern auch das Herausführen des Audiosignals aus dem Stummzustand durch dessen Anwachsenlassen von Null aus mit umfassen.

Die erfindungsgemäße Dämpfungsschaltung wird mittels einer digitalen Ansteuerschaltung angesteuert, bei der es sich beispielsweise um den bereits erwähnten Aufwärts/Abwärts-Zähler, um einen Addierer/Subtrahierer oder um einen Microcontroler handeln kann.

Die Erfindung wird nun anhand von Ausführungsformen näher erläutert. In den Zeichnungen zeigen:

**Fig. 1** ein Blockschaltbild einer Ausführungsform einer erfindungsgemäßen Dämpfungsschaltung, die Dämpfungsglieder einer ersten Art aufweist und mittels eines Aufwärts/Abwärts-Zählers angesteuert wird;

**Fig. 2** ein Dämpfungsglied einer zweiten Art, das für eine erfindungsgemäße Dämpfungsschaltung verwendbar ist; und

**Fig. 3** Audiosignalverläufe bei sich gleichmäßig ändernder Signalamplitude.

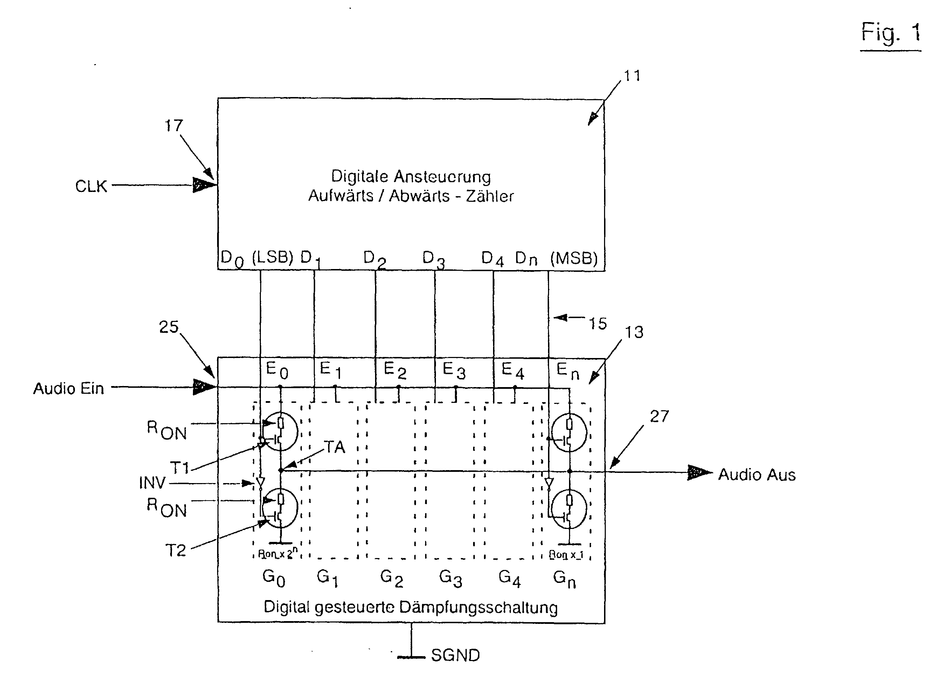

Fig. 1 zeigt eine Ausführungsform einer Dämpfungseinrichtung mit einem Beispiel einer erfindungsgemäßen Dämpfungsschaltung 13, die mittels einer digitalen Ansteuerschaltung in Form eines Aufwärts/Abwärts-Zählers 11 digital angesteuert wird. Der Zähler 11 und die Dämpfungsschaltung 13 sind über eine parallele Datenleitung 15 miteinander verbunden, die bei der in Fig. 1 gezeigten Ausführungsform sechs Einzelleitungen umfaßt.

Der Zähler 11 weist einen Taktimpulseingang 17 auf, dem zu zählende Taktimpulse CLK zuführbar sind. Außerdem weist der Zähler 11 einen Zählstandsignalausgang mit n Zählstandsignalausgangsanschlüssen D0, D1, D2, D3, D4 .... Dn auf, deren Anzahl n der Anzahl der Einzelleitungen der Datenleitung 15 entspricht.

Die Dämpfungsschaltung 13 besitzt einen Audiosignaleingang 25, einen Audiosignalausgang 27, einen Signalmasseanschluß SGND und einen Steuersignaleingang mit n Steuersignaleingangsanschlüssen E0, E1, E2, E3, E4, .... En, wobei n wieder gleich der Anzahl der Einzelleitungen der Datenleitung 15 ist.

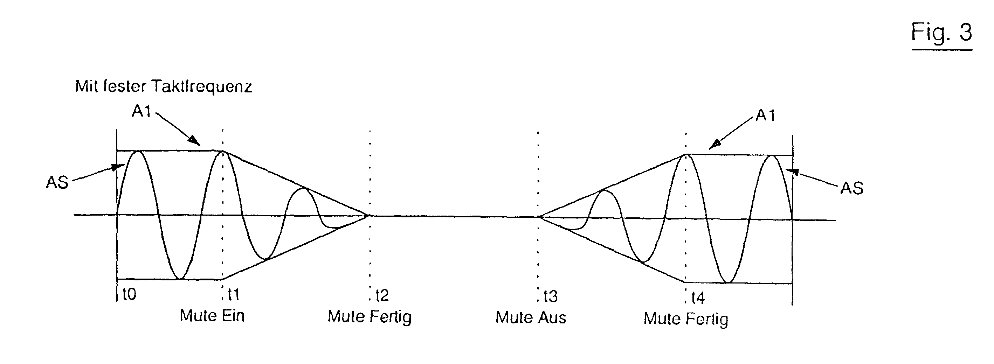

Über die Datenleitung 15 wird der jeweilige Zählstand des Zählers 11 durch ein den Zählstand im Dualzahlensystem darstellendes n-stelliges Datenwort übertragen, wobei n eine ganze Zahl ist. Bei der in Fig. 3 dargestellten Ausführungsform ist n = 6.

Fig. 1 zeigt eine Ausführungsform, bei welcher die Dämpfungsschaltung 13 eine zwischen den Audiosignaleingang 25 und den Audiosignalausgang 27 geschaltete Parallelschaltung mit n Dämpfungsgliedern G0, G1, ... Gn aufweist. Jedes dieser Dämpfungsglieder besitzt einen mit dem Audiosignalausgang 27 verbundenen Teilspannungsabgriff TA sowie einen zwischen den Audiosignaleingang 25 und den Teilspannungsabgriff TA geschalteten ersten MOS-Transistor T1 und einen zwischen den Teilspannungsabgriff TA und den Signalmasseanschluß SGND geschalteten zweiten MOS-Transistor T2. Jeder dieser MOS-Transistoren stellt praktisch die Reihenschaltung aus einem Einschaltwiderstand Ron und einem durch den Schalttransistor gebildeten elektronischen Schalter dar. Die Gateelektroden von T1 und T2 der einzelnen Dämpfungsglieder G0 bis Gn sind je mit einem der Zählstandsignalausgangsanschlüsse D0 bis Dn verbunden, und zwar die Gateelektrode von T1 direkt und die Gateelektrode von T2 über einen Inverter INV, oder umgekehrt, wenn es sich bei T1 und T2 um MOS-Transistoren des gleichen Kanaltyps handelt. Verwendet man für T1 und T2 MOS-Transistoren unterschiedlichen Kanaltyps, ist der Inverter INV nicht erforderlich. Dadurch werden die beiden Transistoren T1 und T2 gegenläufig geschaltet, derart, daß jeweils einer leitend und der jeweils andere nicht leitend geschaltet ist.

Die Einschaltwiderstände Ron der Transistoren T1 und T2 der einzelnen Dämpfungsglieder G0 bis Gn sind unterschiedlich groß, und zwar in Abhängigkeit davon, von welcher Dualzahlenstelle des über die Datenleitung 15 vom Zähler 11 jeweils an die Dämpfungsschaltung 13 übertragenen Datenwortes das jeweilige Dämpfungsglied gesteuert wird. Geht man davon aus, daß den beiden Zählstandsignalausgangsanschlüssen D0 und Dn das niedrigstwertige Bit (LSB) bzw. das höchstwertige Bit (MSB) des Datenwortes zugeordnet ist, nimmt man bei dem dargestellten Ausführungsbeispiel hinsichtlich der Widerstandswerte der Einschaltwiderstände Ron der Dämpfungsglieder G0 bis Gn die Wichtung

$$Ron \times 2^n$$

vor, wobei der niedrigstwertige Einschaltwiderstand Ron x 1 dem dem höchstwertigen Bit zugeordneten Dämpfungsglied Gn zugeordnet ist, während bei dem dargestellten Ausführungsbeispiel mit sechs Zählstandssignalausgangsanschlüssen dem zum niedrigstwertigen Bit gehörenden Dämpfungsglied G0 ein Einschaltwiderstandswert Ron x $2^5$ zugeordnet ist.

Abweichend von der in Fig. 1 dargestellten Ausführungsform können die einzelnen Dämpfungsglieder G0 bis Gn auch mit voneinander bauelementemäßig getrennten Widerständen und Schaltern aufgebaut sein, wobei dann jedes Dämpfungsglied eine zwischen den Audiosignaleingang 25 und den Teilspannungsabgriff TA geschaltete erste Reihenschaltung mit einem ersten Widerstand und einem ersten steuerbaren Schalter und eine zwischen den Teilspannungsabgriff TA und den Signalmasseanschluß SGND geschaltete zweite Reihenschaltung mit einem zweiten Widerstand und einem zweiten gesteuerten Schalter aufweist.

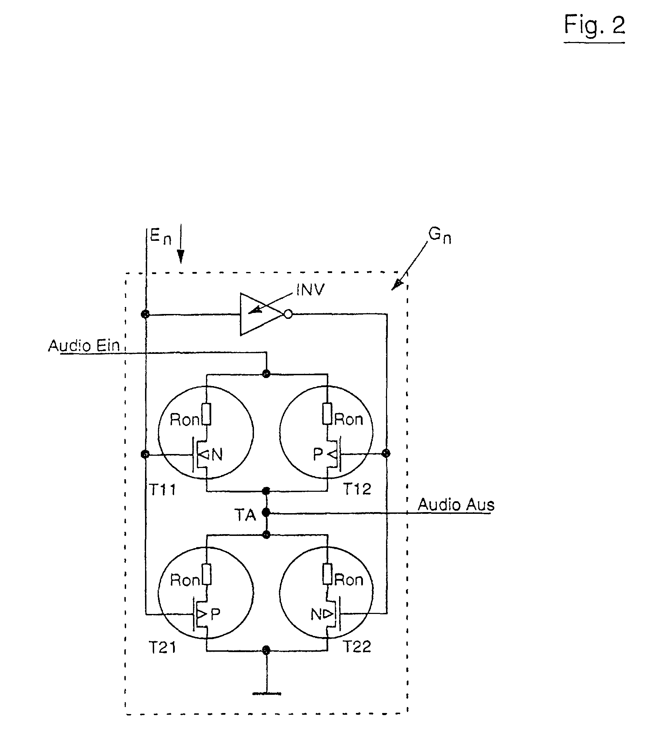

Fig. 2 zeigt eine weitere Möglichkeit eines Dämpfungsgliedes, das für die Dämpfungsschaltung 13 geeignet ist. Dabei sei angenommen, daß in Fig. 2 beispielsweise das Dämpfungsglied Gn dargestellt ist und die anderen Dämpfungsglieder G0 bis G4 identisch aufgebaut sind. Mit einem Dämpfungsglied dieser Art wird die bereits erwähnte Linearitätsverbesserung erreicht.

Im Unterschied zu der in Fig. 1 gezeigten Ausführungsform von Dämpfungsgliedern weist das in Fig. 2 gezeigte Dämpfungsglied zwischen dem Audiosignaleingang 25 und dem Audiosignalausgang 27 einerseits und dem Audiosignalausgang 27 und dem Signalmasseanschluß SGND andererseits je eine Parallelschaltung aus einem NMOS-Transistor T11 bzw. T22 und einem PMOS-Transistor T12 bzw. T21 auf. Die Einschaltwiderstände Ron aller vier Transistoren T11, T12, T21 und T22 sind gleich groß. Die Gateelektroden von T11 und T21 sind direkt und die Gateelektroden von T12 und T22 sind über einen Inverter INV mit dem je zugehörigen der Steuersignaleingangsanschlüsse E0 bis En verbunden. Die vier Transistoren T11, T12, T21 und T22 sind jeweils gegenläufig geschaltet, derart, daß jeweils das Transistorpaar T11 und T12 oder das Transistorpaar T21 und T22 leitend gesteuert und das jeweils andere Transistorpaar nicht leitend gesteuert ist.

Die Dämpfungsschaltung 13 bildet bei den in den Fig. 1 und 2 gezeigten Ausführungsformen zwischen dem Audiosignaleingang 25 und dem Audiosignalausgang 27 einerseits und dem Audiosignalausgang 27 und dem Signalmasseanschluß SGND andererseits je eine Parallelschaltung von mehreren Einschaltwiderständen Ron mit entsprechend den einzelnen Stellen des Dualzahlensystems gewichteten Einschaltwiderstandswerten. Wieviele von den je parallel geschalteten Einschaltwiderständen unterschiedlichen Einschaltwiderstandswertes an der Parallelschaltung jeweils beteiligt sind, hängt von dem jeweiligen Datenwort ab, das über die Datenleitung 15 übertragen wird. Beispielsweise sei angenommen, daß bei einem Binärwert 0 einer Datenwortstelle bei der Ausführungsform von Fig. 1 T1 gesperrt und T2 leitend bzw. bei der in Fig. 2 gezeigten Ausführungsform T11 und T12 gesperrt und T21 und T22 leitend gesteuert sind. Weisen sämtliche Stellen des Datenwortes den Binärwert 0 auf, sind sämtliche zwischen dem Audiosignaleingang 25 und dem Audiosignalausgang 27 befindliche Transistoren gesperrt, während alle zwischen dem Audiosignalausgang 27 und Signalmasse SGND befindlichen Transistoren leitend sind und die Amplitude des am Audiosignalausgang 27 auftretenden Audiosignals praktisch 0 ist. Weisen dagegen sämtliche Stellen des Datenwortes den Logikwert 1 auf, sind sämtliche zwischen dem Audiosignaleingang 25 und dem Audiosignalausgang 27 liegenden Transistoren leitend und alle zwischen dem Audiosignalausgang und der Signalmasse SGND liegenden Transistoren sperrend geschaltet, so daß das Audiosignal zwischen dem Audiosignaleingang 25 und dem Audiosignalausgang 27 praktisch keine Dämpfung erfährt. Bei Datenwörtern, bei denen ein Teil der Datenwortstellen den Logikwert 0 und ein Teil der Datenwortstellen den Logikwert 1 aufweist, tritt am Audiosignalausgang 27 eine Signalamplitude auf, die zwischen 0 und der ungedämpften Amplitude liegt.

Auf diese Weise kann man durch Verändern des Datenwortes der digitalen Ansteuerschaltung eine Änderung der Dämpfung erreichen.

Fig. 3 zeigt ein Audiosignal AS, das vorübergehend einer sich gleichmäßig ändernden Dämpfung durch eine erfindungsgemäße Dämpfungsschaltung unterzogen wird, z.B. für ein weiches Stummschalten des Audiosignals, und das zu einem Zeitpunkt t0 eine konstante Amplitude A1 aufweist.

Zu einem Zeitpunkt t1 wird der beispielsweise mit einem Aufwärts/Abwärts-Zähler 11 aufgebauten digitalen Ansteuerschaltung ein Signal MUTE EIN zugeführt, das einen Zählstart des Zählers 11 in Gang setzt, woraufhin der Zähler 11 die ihm zugeführten Taktimpulse CLK zu zählen beginnt, die ihm mit konstanter Taktfrequenz zugeführt werden. Bei einer schrittweisen Veränderung des Zählstandes des Zählers 11 wird der Gesamtdämpfungsfaktor der digital gesteuerten Dämpfungsschaltung 13 schrittweise verändert, die Amplitude des durch die Dämpfungsschaltung 13 hindurchgeschickten Audiosignals somit schrittweise verändert. Bei einem bestimmten ersten Zählstand des Zählers 11 wird das Audiosignal minimal gedämpft, während es bei einem anderen vorbestimmten Zählstand des Zählers maximal gedämpft wird. Beginnend beim Zeitpunkt t1 beginnt der Zähler von dem minimale Signaldämpfung bewirkende Zählstand aus mit der Zählung in Richtung zu dem maximale Dämpfung bewirkenden Zählstand, der zum Zeitpunkt t2 erreicht wird. Zu diesem Zeitpunkt ist das Audiosignal AS auf Null oder im wesentlichen Null gedämpft, der Vorgang des weichen Stummschaltens somit beendet.

Ist der Vorgang, während welchem eine Stummschaltung erwünscht ist, zum Zeitpunkt t3 beendet, wird mittels der in Fig. 1 gezeigten Dämpfungseinrichtung eine Rückführung des Audiosignals AS zu seiner ungedämpften Amplitude A1 begonnen. Hierfür beginnt der Zähler in umgekehrter Richtung als zwischen den Zeitpunkten t1 und t2 zu zählen, was eine schrittweise geringere Dämpfung des Audiosignals AS durch die Dämpfungsschaltung 13 und somit dessen schrittweise Erhöhung zur Folge hat. Zum Zeitpunkt t4 ist dann wieder der minimale Dämpfung bewirkende Zählstand des Zählers 11 erreicht.

Andere als die in Fig. 3 gezeigten linearen Dämpfungsverläufe kann man dadurch erreichen, daß man dem Takteingang 17 des Zählers 11 ein Taktsignal mit sich ändernder Taktfrequenz zuführt.

Beliebige Dämpfungszwischenwerte in $2^n$ Stufen lassen sich durch Anhalten des Zählers 11 bei der gewünschten Dämpfungsstufe oder durch anderweitige Zuführung des entsprechenden digitalen Datenwortes erreichen.

**Patentansprüche**

1. Digital steuerbare elektrische Dämpfungsschaltung (13) zum steuerbaren Dämpfen eines Audiosignals (AS), die einen Audiosignaleingang (25) aufweist, einen Audiosignalausgang (27) und einen Steuersignaleingang (E0 bis En) für die Verbindung mit einer digitalen Ansteuerschaltung, mittels welcher ein n-stelliges Datenwort an den Steuersignaleingang (E0 bis En) der Dämpfungsschaltung (13) lieferbar ist, wobei n eine vorbestimmte ganze Zahl ist und wobei die Dämpfungsschaltung (13) eine zwischen den Audiosignaleingang (25) und einen Signalmasseanschluß (SGND) geschaltete Parallelschaltung mit n Dämpfungsgliedern (G0 bis Gn) enthält, die je aufweisen:

   einen mit dem Audiosignalausgang (27) verbundenen Teilspannungsabgriff (TA), eine zwischen den Audiosignaleingang (25) und den Teilspannungsabgriff (TA) geschaltete erste Reihenschaltung mit einem ersten Widerstand (Ron) und einem ersten steuerbaren Schalter (T1), eine zwischen den Teilspannungsabgriff (TA) und den Signalmasseanschluß (SGND) geschaltete zweite Reihenschaltung mit einem zweiten Widerstand (Ron) und einem zweiten steuerbaren Schalter (T2) und eine Schaltersteuereinrichtung, über welche die beiden Schalter eines jeden Dämpfungsgliedes gegenläufig steuerbar sind, derart, daß jeweils einer der beiden Schalter (T1, T2) leitend und der jeweils andere Schalter (T2, T1) nichtleitend geschaltet ist, und wobei den Schaltersteuereinrichtungen der Dämpfungsglieder (G0 bis Gn) je eine andere der n Stellen des Datenwortes als Schaltsteuersignal zuführbar ist.

2. Dämpfungsschaltung nach Anspruch 1, bei welcher die Widerstandswerte der Widerstände (Ron) der einzelnen Dämpfungsglieder (G0 bis Gn) verschieden sind, und zwar in Abhängigkeit von den Wertigkeiten der den einzelnen Dämpfungsgliedern (G0 bis Gn) zugeordneten Stellen des Datenwortes.

3. Dämpfungsschaltung nach Anspruch 1 oder 2, bei welcher jeder Schalter mit einem MOS-Schalter aufgebaut ist, dessen Einschaltwiderstand (Ron) den je zugehörigen Widerstand des Dämpfungsgliedes (G0 bis Gn) bildet.

4. Dämpfungsschaltung nach Anspruch 3, bei welcher jeder MOS-Schalter mit einer Parallelschaltung aufgebaut ist, die einen NMOS-Transistor (T11 bzw. T22) und einen PMOS-Transistor (T12 bzw. T21) aufweist, die immer gleichzeitig leitend oder nichtleitend schaltbar sind, wobei im Einschaltzustand deren parallel zueinander liegende Einschaltwiderstände (Ron) den je zugehörigen Widerstand des Dämpfungsgliedes (G0 bis Gn) bilden.

5. Dämpfungsschaltung nach Anspruch 3 oder 4, bei welcher bei jedem Dämpfungsglied (G0 bis Gn) der zum ersten Widerstand gehörende NMOS-Transistor (T11) und der zum zweiten Widerstand gehörende PMOS-Transistor (T21) direkt und der zum ersten Widerstand gehörende PMOS-Transistor (T12) und der zum zweiten Widerstand gehörende NMOS-Transistor (T21) über einen Inverter (INV) mit dem zugehörigen Schaltsteuersignal beaufschlagbar ist, oder umgekehrt.

6. Dämpfungsschaltung nach einem der Ansprüche 1 bis 5, in Verbindung mit einer digitalen Ansteuerschaltung (11), die mit einem Aufwärts/Abwärts-Zähler (11) aufgebaut ist, der einen Taktimpulseingang (17) für die Zuführung von zu zählenden Taktimpulsen (CLK) und einen Zählstandsignalausgang (D0 bis Dn), von dem das n-stellige Datenwort abnehmbar ist, aufweist.

**Claims**

1. A digitally controllable electrical attenuation circuit (13) for controllably attenuating an audio signal (AS), comprising an audio signal input (25), an audio signal output (27) and a control signal input (E0 to En) for connection to a digital control circuit, by means of which an n-position data word can be supplied to the control signal input (E0 to En) of the attenuation circuit (13), with n being a predetermined integer and the attenuation circuit (13) containing a parallel connection connected between audio signal input (25) and a signal ground terminal (SGND) and including n attenuation members (G0 to Gn) each comprising:

a partial voltage tap (TA) connected to audio signal output (27), a first series connection connected between audio signal input (25) and partial voltage tap (TA) and including a first resistor (Ron) and a first controllable switch (T1), a second series connection connected between partial voltage tap (TA) and signal ground terminal (SGND) and including a second resistor (Ron) and a second controllable switch (T2), and a switch control means through which the two switches of each attenuation member are controllable in opposite manner such that in each particular case one of the two switches (T1, T2) is rendered conducting and the respective other switch (T2, T1) is rendered non-conducting, and with the switch control means of the attenuation members (G0 to Gn) being each adapted to be fed with a different one of the n positions of the data word as switching control signal.

2. The attenuation circuit of claim 1, in which the resistances of the resistors (Ron) of the individual attenuation members (G0 to Gn) are different, depending on the significance of the positions of the data word associated with the individual attenuation members (G0 to Gn).

3. The attenuation circuit of claim 1 or 2, in which each switch is composed with a MOS switch the ON-resistor (Ron) of which constitutes the respectively associated resistor of the attenuation member (G0 to Gn).

4. The attenuation circuit of claim 3, in which each MOS switch is composed with a parallel connection having an NMOS transistor (T11 and T22, respectively) and a PMOS transistor (T12 and T21, respectively) which can be rendered conducting and non-conducting always at the same time, wherein, in the on-state, the ON-resistors (Ron) thereof arranged parallel to each other constitute the respectively associated resistor of the attenuation member (G0 to Gn).

5. The attenuation circuit of claim 3 or 4, in which, for each attenuation member (G0 to Gn), the NMOS transistor (T11) belonging to the first resistor and the PMOS transistor (T21) belonging to the second resistor are adapted to have the associated switching control signal applied there to directly, and the PMOS transistor (T12) belonging to the first resistor and the NMOS transistor (T21) belonging to the second resistor are adapted to have the associated switching control signal applied thereto via an inverter (INV), or vice versa.

6. The attenuation circuit of any one of claims 1 to 5, in conjunction with a digital control circuit (11) composed with an up/down counter (11) having a clock pulse input (17) for feeding of clock pulses (CLK) to be counted and a count signal output (D0 to Dn) from which the n-position data word is available.

**Revendications**

1. Circuit atténuateur électrique à commande numérique (13) pour l'atténuation réglable d'un signal audio (AS), présentant une entrée de signal audio (25), une sortie de signal audio (27) et une entrée de signal de commande (E0 à En) pour être reliée à un circuit de commande numérique, au moyen duquel un mot de données à n chiffres peut être fourni à l'entrée de signal de commande (E0 à En) du circuit atténuateur (13), n étant un nombre entier prédéterminé et le circuit atténuateur (13) comprenant un circuit parallèle avec n éléments atténuateurs (G0 à Gn), disposé entre l'entrée de signal audio (25) et un branchement de masse de signal (SGND), chacun des éléments atténuateurs présentant :

- une prise de tension partielle (TA) reliée à la sortie de signal audio (27),

- un premier circuit série monté entre l'entrée de signal audio (25) et la prise de tension partielle (TA) et comprenant une première résistance (Ron) et un premier commutateur (T1) commandable,

- un deuxième circuit série monté entre la prise de tension partielle (TA) et le branchement de masse de signal (SGND) et comprenant une deuxième résistance (Ron) et un deuxième commutateur (T2) commandable,

- et un dispositif de commande de commutateurs permettant de commander en sens contraires les deux commutateurs de chaque élément atténuateur, de telle sorte que l'un des deux commutateurs (T1, T2) est conducteur et l'autre commutateur (T2, T1) n'est pas conducteur,

- et les dispositifs de commande de commutateurs des éléments atténuateurs (G0 à Gn) pouvant recevoir respectivement un autre des n chiffres du mot de données à titre de signal de commutation.

2. Circuit atténuateur selon la revendication 1, dans lequel les valeurs ohmiques des résistances (Ron) des différents éléments atténuateurs (G0 à Gn) sont différentes, et ceci en fonction des poids des chiffres du mot de données associés aux différents éléments atténuateurs (G0 à Gn).

3. Circuit atténuateur selon la revendication 1 ou 2, dans lequel chaque commutateur comprend un commutateur MOS dont la résistance à l'état passant (Ron) constitue la résistance respectivement associée à l'élément atténuateur (G0 à Gn).

4. Circuit atténuateur selon la revendication 3, dans lequel chaque commutateur MOS comprend un circuit parallèle comportant un transistor NMOS (T11 ou T22) et un transistor PMOS (T12 ou T21), qui sont toujours en même temps conducteurs ou non conducteurs, leurs résistances (Ron) en parallèle constituant, à l'état passant, la résistance respectivement associée à l'élément atténuateur (G0 à Gn).

5. Circuit atténuateur selon la revendication 3 ou 4, dans lequel, pour chaque élément atténuateur (G0 à Gn), le transistor NMOS (T11) associé à la première résistance et le transistor PMOS (T21) associé à la deuxième résistance peuvent recevoir directement le signal de commutation associé, et le transistor PMOS (T12) associée à la première résistance et le transistor NMOS (T22) associée à la deuxième résistance peuvent recevoir ce signal par l'intermédiaire d'un inverseur (INV), ou inversement.

6. Circuit atténuateur selon l'une des revendications 1 à 5, en combinaison avec un circuit de commande numérique (11) constitué par un compteur/décompteur (11), qui comporte une entrée d'impulsions d'horloge (17) pour recevoir des impulsions d'horloge (CLK) à compter et une sortie de signal d'état de comptage (D0 à Dn), de laquelle on peut prélever le mot de données à n chiffres.

EP 0 821 477 B1

Fig. 1

Digitale Ansteuerung
Aufwärts / Abwärts - Zähler

CLK

$D_0$ (LSB) $D_1$ $D_2$ $D_3$ $D_4$ $D_n$ (MSB)

Audio Ein

$E_0$ $E_1$ $E_2$ $E_3$ $E_4$ $E_n$

$R_{ON}$

TA

T1

INV

$R_{ON}$

T2

$R_{on} \times 2^n$ $R_{on} \times 1$

$G_0$ $G_1$ $G_2$ $G_3$ $G_4$ $G_n$

Digital gesteuerte Dämpfungsschaltung

Audio Aus

SGND

Fig. 2

Fig. 3